# EUROPEAN PATENT SPECIFICATION

(11) **EP 3 203 146 B1**
(45) Date of publication and mention of the grant of the patent: **31.10.2018**
(21) Application number: 17152604.9
(22) Date of filing: 23.01.2017
(51) Int. Cl.: F21V 21/096, F21V 29/503, F21S 4/24, F21Y 103/10, F21Y 115/10

(54) **SUPPORT STRUCTURE FOR LIGHT RADIATION SOURCES, CORRESPONDING DEVICE AND METHOD**
STÜTZSTRUKTUR FÜR LICHTSTRAHLUNGSQUELLEN, ZUGEHÖRIGE VORRICHTUNG UND VERFAHREN
STRUCTURE SUPPORT POUR SOURCES DE RAYONNEMENT LUMINEUX, DISPOSITIF ET PROCÉDÉ CORRESPONDANTS

(30) Priority: 08.02.2016 IT UB20160552
(43) Date of publication of application: 09.08.2017
(73) Proprietor: OSRAM GmbH, 80807 München (DE); OSRAM S.P.A. - SOCIETA' RIUNITE OSRAM EDISON CLERICI, 20126 Milano (IT)
(72) Inventor: SCORDINO, Alessandro, I-30031 Dolo (Venezia) (IT); VAN DER MEER, Geert, 85737 Ismaning (NL); VOLPATO, Luca, I-31022 Preganziol (Treviso) (IT)
(74) Representative: Bosotti, Luciano

(56) References cited:
- WO-A1-2011/151272
- DE-A1-102007 002 838
- JP-A- 2012 043 756
- US-A1- 2010 277 666
- US-A1- 2015 159 812

## Description

### Technical Field

The description relates to lighting devices.

One or more embodiments may find application in lighting devices employing electrically-powered light radiation sources such as solid-state sources, e.g. LED sources.

### Technological Background

Lighting devices including an elongate, e.g. ribbon-like, and flexible support, whereon light radiation sources such as LED sources are mounted, may offer a high degree of installation flexibility. Users (installers and possibly final users) may cut strings of proper length from a continuous reel.

This procedure may however involve power limitations of the lighting sources, due to the heat generated by the latter in operation, to the requirements of the mounting surface (for example, wood or flammable materials must be avoided) or to the need of employing dedicated mounting profiles having thermally dissipative properties.

For example, in order to avoid exceeding temperature safety limits, LED modules adapted to be cut to a desired length and to be used in power applications may require being mounted on thermally dissipative surfaces.

In the case of mounting on non-dissipative surfaces (e.g. wood, plastic materials, certain kinds of drywalls), mounting profiles having thermal dissipation properties may be resorted to. Such profiles may however impose limitations due to their rigidity; this may reduce the benefits deriving from the flexibility of the lighting module itself.

Moreover, such modules may be destined to be applied onto the mounting surface and/or into the thermally dissipative profile by means of an adhesive tape. The latter may form an additional thermal interface which may further limit thermal dissipation from light radiation sources, e.g. LED sources. The possible use of thermally conductive adhesive tapes has the disadvantage of a rather high cost.

A further possible solution consists in using, as support surfaces for light radiation sources, semi-rigid elements similar to Printed Circuit Boards (PCBs) and made of materials such as Kapton or Aluminium. However, the drawback of this solution is the availability of such supports as single PCBs or panels, not as continuous reels which may be cut to length. This is an obvious limitation, as the presence of a continuous ribbon is one of the main advantages of flexible ("flex") LED modules.

Document US 8 975 532 B2 shows a solution wherein thermal dissipation may be favoured by means of copper pads on the PCB, which requires a certain width of the Flexible Printed Circuits (FPCs) or strips, with a consequent limitation of the possible application fields.

Document DE 102007002838 A1 discloses a motor vehicle lamp, for internal and external illumination, having a number of LEDs directly bonded to a cooling body to take off the heat loss therefrom. Also, the lamp includes a housing of a heat-conductive material for at least one LED, held in an opening or recess in the cooling body in a force fit. Each LED is within its own cooling element, in contact with the housing.

Also, documents US 2010/277666 A1, JP 2012043756 A, US 2015/159812 A1 and WO 2011/151272 A1 may be of interest for the present disclosure.

### Object and Summary

One or more embodiments aim at overcoming the previously outlined limitations.

According to one or more embodiments, said object may be achieved thanks to a support structure for lighting devices having the features specifically set forth in the claims that follow.

One or more embodiments may also concern a corresponding lighting device, as well as a corresponding method.

The claims are an integral part of the technical teaching provided herein with reference to the embodiments.

In one or more embodiments, the problem of providing a satisfying level of thermal dissipation in flexible lighting modules, e.g. so-called "flex" modules, is solved via the application of thermally dissipative elements, so as to preserve the intrinsic advantages of ribbon-like modules which may be cut to length.

One or more embodiments enable to achieve one or more of the following advantages:
- higher thermal dissipation capability than standard flexible, e.g. LED, strips/modules, the possibility being given of using thermally dissipative elements integrated as stand-alone components, without the need of providing additional heatsinks (so-called self-cooling capability), and with the option of installation on non-thermally dissipative supports;
- possibility of manufacturing continuous modules, e.g. as flexible strips, adapted to be cut to length by final users, the possibility being offered of reducing manufacturing costs while avoiding splicing (another advantage for final users);
- possibility of implementing an in-house lamination of thermally dissipative elements, with a consequent increase of the product portfolio, because the same module may be marketed both with and without the provision of thermally dissipative elements;
- benefits regarding shipping, stocking and generally handling thanks to the possible use of reel-to-reel technology, while enhancing the thermal dissipation properties of the flexible modules themselves;
- possibility of coupling strip-shaped substrates, e.g. adapted to carry power LEDs, to thermally dissipative elements having various sizes and shapes, with the consequent option of further widening the product portfolio by using only a small number of premanufactured flexile modules;
- possibility of using the thermally dissipative elements in order to implement alternative installation methods, which show a higher efficiency in thermal dissipation than e.g. adhesive tapes; for instance, magnetic inserts may be provided on thermally dissipative elements, so as to enable the fixation on ferromagnetic materials; as an alternative, holes may be present for a fixation via screws;
- possibility of using the thermally dissipative elements as supports for lenses or other optical accessories, which may be coupled to the thermally dissipative elements e.g. via screws, mechanical interference or clips.

### Brief Description of the Figures

One or more embodiments will now be described, by way of non-limiting example only, with reference to the annexed Figures, wherein:
- Figure 1 exemplifies a general principle on which one or more embodiments may be based,
- Figures 2 and 3 exemplify, respectively in side elevation and in top view, one or more embodiments,
- Figures 4 and 5 exemplify, in further top views, one or more embodiments,
- Figures 6 to 8 exemplify various possible implementations of embodiments, and
- Figures 9 and 10 exemplify possible implementation criteria of methods according to one or more embodiments.

It will be appreciated that, for clarity of illustration, the various Figures may not be drawn to the same scale.

### Detailed Description

In the following description, numerous specific details are given in order to provide a thorough understanding of various exemplary embodiments. The embodiments may be practiced without one or several of the specific details, or with other methods, components, materials, etc. In other instances, well-known structures, materials, or operations are not shown or described in detail to avoid obscuring the various aspects of the embodiments.

Reference throughout this specification to "one embodiment" or "an embodiment" means that a particular feature, structure, or characteristic described in connection with the embodiment is included in at least one embodiment. Thus, the possible appearances of the phrases "in one embodiment" or "in an embodiment" in various places throughout this specification are not necessarily all referring exactly to the same embodiment. Furthermore, particular features, structures, or characteristics may be combined in any suitable manner in one or more embodiments.

The headings provided herein are given for convenience only, and therefore do not interpret the extent of protection or the scope of the embodiments.

One or more embodiments may envisage the integration of thermally dissipative elements (e.g. of a metal material such as copper), having a plurality of shapes, into a ribbon-like elongate assembly, substantially similar to a Printed Circuit Board (PCB), carrying electrically-powered light radiation sources, such as e.g. solid-state light radiation sources, e.g. LED sources, and/or possible further elements adapted to generate heat in operation: by way of non-limiting example we may mention the drivers / regulating circuits which may be associated to the previously mentioned light radiation sources.

In one or more embodiments, reference 10 denotes a ribbon-like substrate or support, substantially similar to a Flexible Printed Circuit (FPC).

In one or more embodiments, support 10 may include a continuous strip, including at least one electrically insulating layer and at least one electrically conductive layer.

In one or more embodiments, the electrically insulating layer may include e.g. a polymer, such as polyimide or other materials known for this purpose (e.g. polyethylene naphtalate, polyester, FR4).

In one or more embodiments, the electrically conductive layer may take the form of an arrangement or pattern of electrically conductive (e.g. copper) lines, which may be used for supplying (and optionally for controlling e.g. the temperature or the light emission intensity - so-called "dimming") of electrically-powered light radiation sources, such as solid-state sources e.g. LED sources.

In one or more embodiments such sources, denoted as 12, may be mounted at mounting locations 120 arranged on the front face of substrate 10.

On said substrate (e.g. on the front face or surface thereof) there may optionally be arranged electric/electronic components/circuits 12, for the supply and/or the driving of sources 12, e.g. in order to perform current regulating and/or voltage balancing functions, according to the application needs. Such lighting modules/devices are known in themselves, which makes it unnecessary to provide a more detailed description herein.

One or more embodiments may envisage the coupling, to the presently exemplified support structure, of thermally dissipative elements 14, arranged on the back face o side of substrate 10, i.e. on the side or face opposed the (front) face whereon sources 12 will be placed (together with circuits 12 optionally associated therewith).

In one or more embodiments, thermally dissipative elements 14 may include (or may be comprised of) plates of thermally conductive material, e.g. a metal material such as copper.

In one or more embodiments (and as schematically exemplified in the Figures), said elements may include single elements 14 arranged on the back face of substrate 10 and located opposed the locations 120 on the front face, for mounting sources 12 (and/or the associated circuits 12a, which may be located in the vicinity thereof).

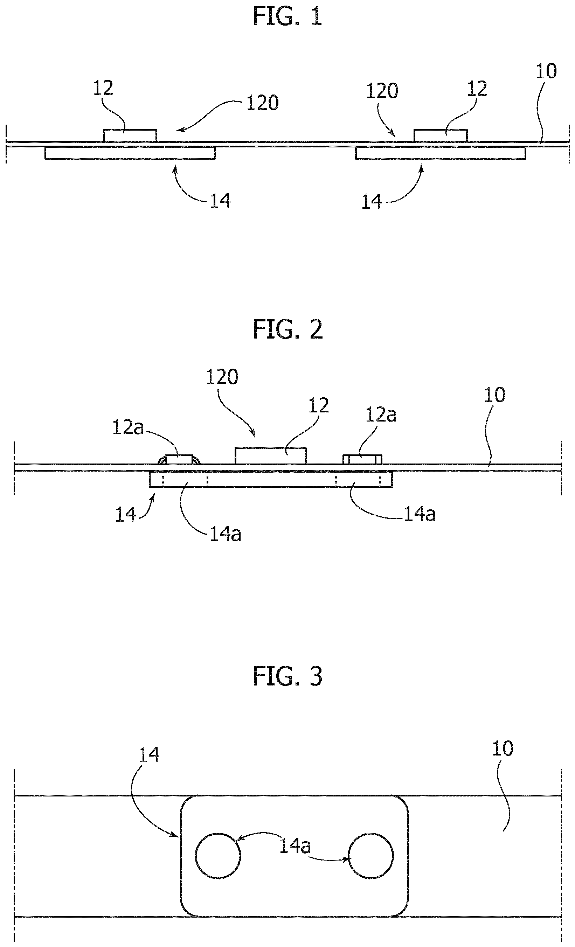

In one or more embodiments (as exemplified in Figure 3), elements 14 and element 10 may have the same width (in the transverse direction with reference to the lengthwise extension of substrate 10), e.g. in the view of a possible fixation of elements 14 on substrate 10, e.g. via an adhesive tape.

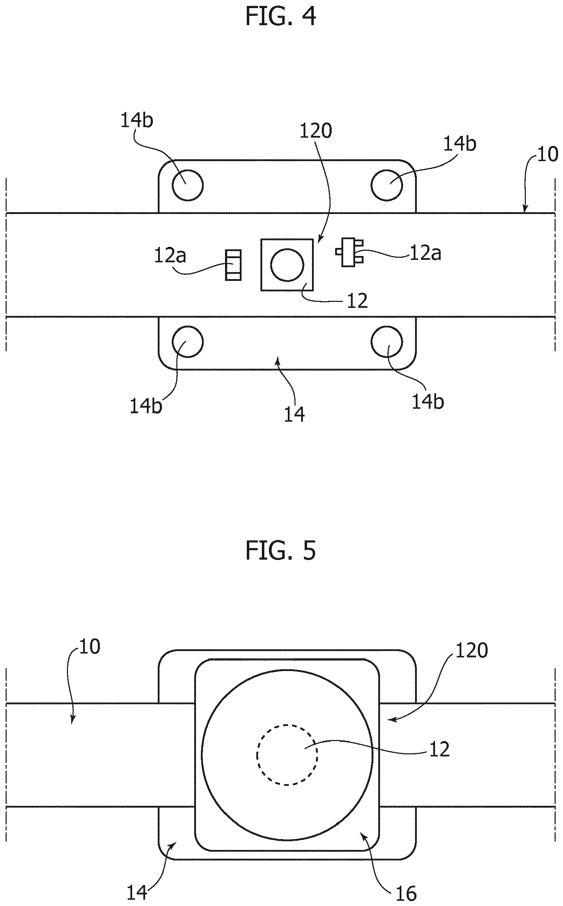

In one or more embodiments, as exemplified e.g. in Figures 4 and following, the thermally dissipative elements 14 may have a width (again in the transverse direction with reference to the lengthwise extension of substrate 10) larger than the width of substrate 10.

In one or more embodiments other fixation procedures may be used for the coupling of elements 14 to substrate 10.

For example, Figures 2 and 3 exemplify the possibility of providing thermally dissipative elements 14 with one or more magnetic inserts 14a.

In one or more embodiments, such magnetic inserts (or, optionally, the presence of magnetic features not only in the insert or inserts 14a but in the element 14 as a whole) may enable mounting on a magnetically attractable surface and, optionally, may also help retaining element 14 on substrate or support 10 by taking advantage of the ferromagnetic properties of support 10 itself, which are given e.g. by the presence of the electrically conductive layer including the electrically conductive lines for supplying and/or controlling sources 12.

In one or more embodiments (as may be the case of the embodiments exemplified in Figures 4 and following, the elements 14 having a larger width than substrate 10), holes 14 may be provided in elements 14, to enable e.g. the fixation of accessories, such as e.g. optical accessories as optical accessories as exemplified in Figures 5 to 8.

What previously exemplified is of course representative of only a few possible implementation examples of the embodiments.

In one or more embodiments which are provided with fixation holes (see e.g. holes 14b), substrate 10 may be arranged sandwich-like, optionally clamped, between the thermally dissipative element 14 and a complementary element 16.

In one or more embodiments, said element 16 may comprise, for example, an optical element such as a lens 16 or a reflector, adapted to be arranged in a position corresponding to the light radiation source 12, so as to perform e.g. a shaping action on the light radiation emitted by the Light Emitting Source (LES) of source 12.

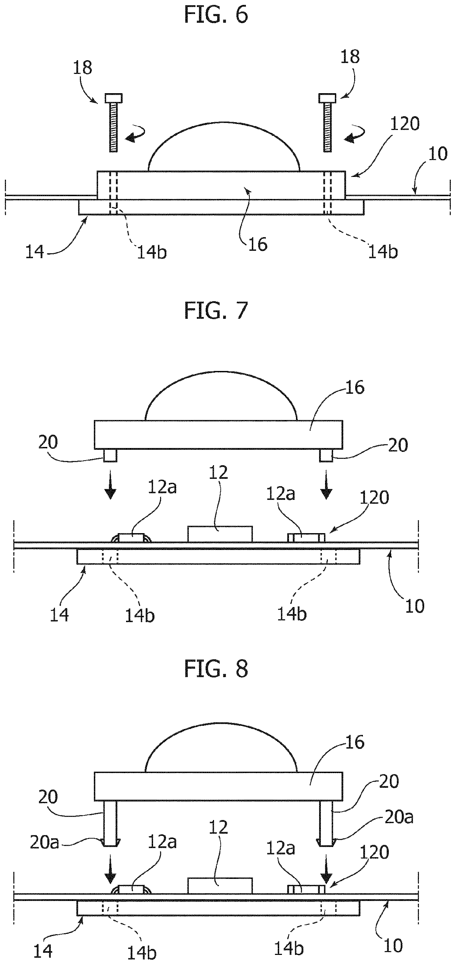

The connection between the thermally dissipative element 14 and the complementary element 16 (e.g. a lens or a reflector), which clamp or enclose substrate 10 sandwich-like therebetween, may be obtained by various means such as, for example:
- screws 18 threading within holes 14b (Figure 6),
- pins achieving an interference fit within holes 14b (Figure 7),
- pins 20 having protruding formations (clips) 20a in their distal portion, which may achieve an interference fit within holes 14b (Figure 8).

In such embodiments, the thermally dissipative element 14 may be wider than substrate 10, the holes 14 being located externally of the edges of substrate 10 (see e.g. Figure 4), so that said fixation elements (screws 18 or pins 20) may extend within holes 14b sidewise of support 10.

In one or more embodiments, thermally dissipative elements 14 may be coupled to support 10 by lamination.

Such a method (known in itself) may envisage the application, between elements 14 and substrate 10, of an adhesive which is dispensed as a glue or is formed as a layer (adhesive tape).

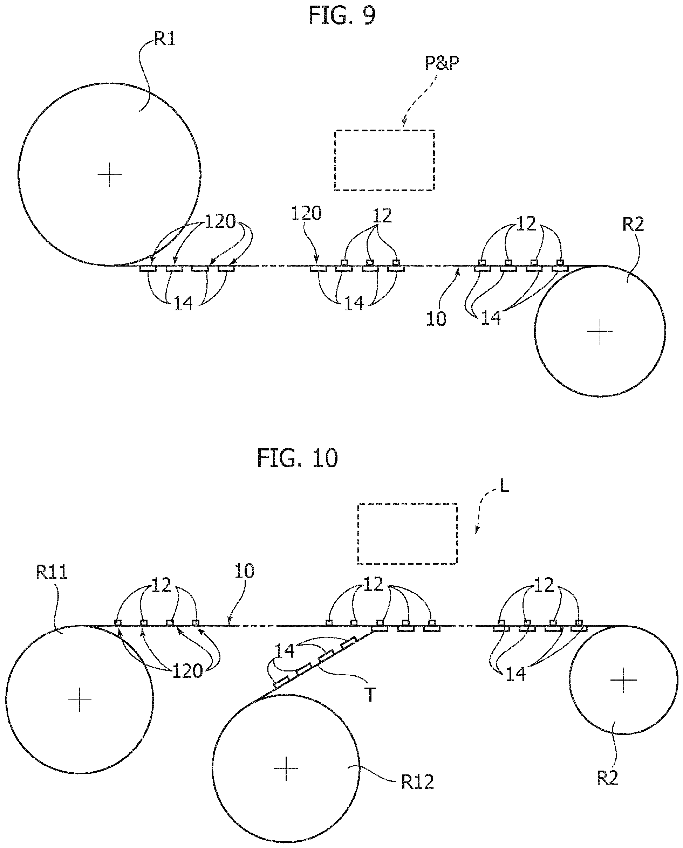

Figure 9 shows, by way of example, a solution wherein the support structure including substrate 10 with elements 14 applied on the back face is unwound from a ribbon or reel R1, then is fed to a P&P processing station in which (e.g. by means of a Pick & Place procedure) light radiation sources 12 (with optional associated circuits which are not visible in the Figures) are applied on the front face of ribbon 10, in positions corresponding to locations 120.

The subsequent step consists in winding the thus finished lighting device onto an output ribbon or reel R2.

A method as schematically shown in Figure 9 may be implemented in manufacturing support 10 as a Flexible Printed Circuit (FPC) so as to obtain a so-called panel.

A process as exemplified in Figure 9 may be implemented in parallel on a plurality of substrates 10, which are unwound from reel R1 as a single sheet and are subsequently separated via a lengthwise cut at the end of the manufacturing process, so as to originate a plurality of LED strips or modules which may be cut to length according to the application needs.

Figure 10 exemplifies, as an overall similar solution, the possibility of unwinding substrate 10, which is already provided with light radiation sources 12 on the front face, from a reel R11, and feeding it to a lamination station schematically denoted as L.

In station L, thermally dissipative elements 14 may be applied (again according to the previously outlined method) onto the back face of substrate 10, at distances which are set according to the mounting locations 120 of sources 12.

In one or more embodiments, elements 14 may be carried by an auxiliary tape T which is unwound from reel R12.

This enables an in-house coupling operation with a conventional lighting device, available on the market, which comprises a substrate 10 having the light radiation sources 12 already mounted on its front face.

As in the case of Figure 9, the resulting lighting device (i.e. support 10 having the light radiation sources 12 on the front face and the thermally dissipative elements 14 on the back face) may be wound onto an output reel R2.

Also in this instance, the coupling operations of the ribbons unwound from reels R11 and R12 may take place on laminar panels, which are subsequently divided into single strips (or proper modules) via a lengthwise cutting operation, as a final processing step.

One or more embodiments, therefore, may include (e.g. in a lighting device) a support structure for electrically-powered light radiation sources, the structure including a ribbon-like flexible substrate having ferromagnetic properties (e.g. 10) the front surface whereof comprises mounting locations (e.g. 120) for light radiation sources distributed therealong, the ribbon-like substrate having a back face opposed said front face with a plurality of thermally dissipative elements (e.g. 14) including at least one magnetic portion (14a) magnetically coupled to the back face of the ribbon-like substrate in positions opposed said mounting locations on said front surface, wherein the thermally dissipative elements (14) cooperate with a complementary element (16), with the ribbon-like substrate (10) sandwiched between the thermally dissipative element (14) and the complementary element (16) .

In one or more embodiments, said thermally dissipative elements may be coupled to the back surface of the ribbon-like substrate by laminating them onto the ribbon-like substrate.

In one or more embodiments, a support structure as exemplified herein may be used in order to obtain a lighting device comprising, in addition to such a support structure, a plurality of electrically-powered light radiation sources (e.g. 12), preferably solid-state sources such as LED sources, which are arranged at said mounting locations on said front surface.

In one or more embodiments, said lighting device may be implemented in various ways such as, for example:
- by providing a support structure as previously exemplified, and arranging (in succession) said light radiation sources on said support structure at said mounting locations on said front surface (see for example the diagram in Figure 9),
   or
- by providing said ribbon-like substrate (e.g. 10) having said light radiation sources (already) arranged at said mounting locations on said front surface, and by magnetically coupling said thermally dissipative elements including at least one magnetic portion to the back surface of the ribbon-like substrate, in said positions opposed said mounting locations on said front surface, with said light radiation sources (already) arranged in the corresponding positions (see e.g. the diagram in Figure 10), with the ribbon-like substrate (10) sandwiched between the thermally dissipative element (14) and the complementary element (16).

Of course, without prejudice to the basic principle, the implementation details and the embodiments may vary, even appreciably, with respect to what has been described herein by way of non-limiting example only, without departing from the extent of protection.

The extent of protection is defined by the annexed claims.

## Claims

1. A support structure for light radiation sources (12), the structure including a ribbon-like flexible substrate (10) having ferromagnetic properties with a front surface having, distributed therealong, mounting locations (120) for electrically-powered light radiation sources (12), the ribbon-like substrate (10) having a back surface opposed said front surface with a plurality of thermally dissipative elements (14) including at least one magnetic portion (14a) magnetically coupled to the back surface of the ribbon-like substrate (10) at locations opposed said mounting locations (120) on said front surface,
wherein said thermally dissipative elements (14) cooperate with a complementary element (16), with the ribbon-like substrate (10) sandwiched between the thermally dissipative element (14) and the complementary element (16).

2. The support structure of claim 1, wherein said thermally dissipative elements (14) include metal material, preferably metal plates.

3. The support structure of claim 1 or claim 2, wherein the ribbon-like substrate (10) has a width across its length and said thermally dissipative elements (14) have a width equal to the width of the ribbon-like substrate (10).

4. The support structure of claim 1 or claim 2, wherein the ribbon-like substrate (10) has a width across its length and said thermally dissipative elements (14) have a width larger than the width of the ribbon-like substrate (10).

5. The support structure of any of the previous claims, wherein said thermally dissipative elements (14) are coupled to the back surface of said ribbon-like substrate (10) by lamination (L) to the ribbon-like substrate (10).

6. The support structure of any of the previous claims, wherein said complementary element (16) includes an optical element.

7. A lighting device, including:
- a support structure according to any of claims 1 to 6, and
- a plurality of electrically-powered light radiation sources (12), preferably solid-state sources such as LED sources LED (12), arranged at said mounting locations (120) on said front surface.

8. A method of providing a lighting device according to claim 7, including one out of:
- providing a support structure according to any of claims 1 to 6 and arranging said light radiation sources (12) on said support structure at said mounting locations (120) on said front surface, or
- providing said ribbon-like substrate (10) with said light radiation sources (12) arranged at said mounting locations (120) on said front surface, and magnetically coupling said thermally dissipative elements (14) including at least one magnetic portion (14a) to the back surface of the ribbon-like substrate (10) at said locations opposed said mounting locations (120) on said front surface with said light radiation sources (12) arranged thereat, with the ribbon-like substrate (10) sandwiched between the thermally dissipative element (14) and the complementary element (16) .

## Patentansprüche

1. Stützstruktur für Lichtstrahlungsquellen (12), wobei die Struktur ein bandartiges flexibles Substrat (10) beinhaltet, welches ferromagnetische Eigenschaften aufweist, mit einer Frontoberfläche, die dort entlang verteilt, Befestigungsorte (120) für elektrisch betriebene Lichtstrahlungsquellen (12) aufweist, wobei das bandartige Substrat (10) eine Rückoberfläche aufweist, die der Frontoberfläche gegenüberliegt, mit einer Vielzahl von thermisch dissipativen Elementen (14), die zumindest einen magnetischen Abschnitt (14a) beinhalten, der magnetisch mit der Rückoberfläche des bandartigen Substrats (10) an Orten gegenüber den Befestigungsorten (120) auf der Frontoberfläche gekoppelt ist,
wobei die thermisch dissipativen Elemente (14) mit einem komplementären Element (16) zusammenwirken, wobei das bandartige Substrat (10) zwischen dem thermisch dissipativen Element (14) und dem komplementären Element (16) sandwichartig angeordnet ist.

2. Stützstruktur nach Anspruch 1, wobei die thermisch dissipativen Elemente (14) ein metallisches Material beinhalten, vorzugsweise Metallplatten.

3. Stützstruktur nach Anspruch 1 oder Anspruch 2, wobei das bandartige Substrat (10) über seine Länge eine Breite aufweist und die thermisch dissipativen Elemente (14) eine Breite aufweisen, die gleich zu der Breite des bandartigen Substrats (10) ist.

4. Stützstruktur nach Anspruch 1 oder Anspruch 2, wobei das Anzeigesubstrat (10) über seine Länge eine Breite aufweist und die thermisch dissipativen Elemente (14) eine Breite aufweisen, die größer ist als die Breite des bandartigen Substrats (10).

5. Stützstruktur nach irgendeinem der vorhergehenden Ansprüche, wobei die thermisch dissipativen Elemente (14) mit der Rückoberfläche des bandartigen Substrats (10) durch Laminierung (L) an das bandartige Substrat (10) gekoppelt sind.

6. Stützstruktur nach irgendeinem der vorhergehenden Ansprüche, wobei das komplementäre Element (16) ein optisches Element beinhaltet.

7. Beleuchtungsvorrichtung, beinhaltend:
- eine Stützstruktur gemäß einem der Ansprüche 1 bis 6, und
- eine Vielzahl von elektrisch betriebenen Lichtstrahlungsquellen (12), vorzugsweise Festkörperquellen, wie beispielsweise LED-Quellen LED (12), die an den Befestigungsorten (120) auf der Frontoberfläche angeordnet sind.

8. Verfahren zum Bereitstellen einer Beleuchtungsvorrichtung gemäß Anspruch 7, wobei das Verfahren eines von Folgendem beinhaltet:
- Bereitstellen einer Stützstruktur gemäß einem der Ansprüche 1 bis 6 und Anordnen der Lichtstrahlungsquellen (12) auf der Stützstruktur an den Befestigungsorten (120) auf der Frontoberfläche, oder
- Bereitstellen des bandartigen Substrats (10), mit den Lichtstrahlungsquellen (12) angeordnet an den Montageorten (120) auf der Frontoberfläche, und magnetisches Koppeln der thermisch dissipativen Elemente (14), einschließlich zumindest eines magnetischen Abschnittes (14a), an die Rückoberfläche des bandartigen Substrats (10) an den Orten gegenüber den Montageorten (120) auf der Frontoberfläche, mit den Lichtstrahlungsquellen (12), die daran angeordnet sind, mit dem bandartigen Substrat (10), das zwischen dem thermisch dissipativen Element (14) und dem komplementären Element (16) sandwichartig angeordnet ist.

## Revendications

1. Une structure support pour des sources de rayonnement lumineux (12), la structure comprenant un substrat flexible semblable à un ruban (10) présentant des propriétés ferromagnétiques avec une surface frontale possédant, distribués sur sa longueur, des emplacements de montage (120) pour des sources de rayonnement lumineux alimentées électriquement (12), le substrat semblable à un ruban (10) ayant une surface dorsale opposée à ladite surface frontale avec une pluralité d'éléments dissipateurs thermiques (14) comprenant au moins une partie magnétique (14a) magnétiquement couplée à la surface dorsale du substrat semblable à un ruban (10) au niveau d'emplacements opposés auxdits emplacements de montage (120) sur ladite surface frontale,
dans laquelle lesdits éléments dissipateurs thermiques (14) coopèrent avec un élément complémentaire (16), avec le substrat semblable à un ruban (10) pris en sandwich entre l'élément dissipateur thermique (14) et l'élément complémentaire (16).

2. La structure support de la revendication 1, dans laquelle lesdits éléments dissipateurs thermiques (14) comprennent un matériau thermique, de préférence des plaques métalliques.

3. La structure support de la revendication 1 ou de la revendication 2, dans laquelle le substrat semblable à un ruban (10) présente une largeur sur l'étendue de sa longueur, et lesdits éléments dissipateurs thermiques (14) présentent une largeur égale à la largeur du substrat semblable à un ruban (10).

4. La structure support de la revendication 1 ou de la revendication 2, dans laquelle le substrat semblable à un ruban (10) présente une largeur sur l'étendue de sa longueur, et lesdits éléments dissipateurs thermiques (14) présentent une largeur supérieure à la largeur du substrat semblable à un ruban (10).

5. La structure support de l'une des revendications précédentes, dans laquelle lesdits éléments dissipateurs thermiques (14) sont couplés à la surface dorsale dudit substrat semblable à un ruban (10) par stratification (L) sur le substrat semblable à un ruban (10).

6. La structure support de l'une des revendications précédentes, dans laquelle ledit élément complémentaire (16) comprend un élément optique.

7. Un dispositif d'éclairage, comprenant :
- une structure support selon l'une des revendications 1 à 6, et
- une pluralité de sources de rayonnement lumineux alimentées électriquement (12), de préférence des sources à l'état solide telles que des sources LED (12), agencées au niveau desdits emplacements de montage (120) sur ladite surface frontale.

8. Un procédé d'obtention d'un dispositif d'éclairage selon la revendication 7, comprenant l'une d'entre :
- l'obtention d'une structure support selon l'une des revendications 1 à 6 et l'agencement desdites sources de rayonnement lumineux (12) sur ladite structure support au niveau desdits emplacements de montage (120) sur ladite surface frontale, ou
- l'obtention dudit substrat semblable à un ruban (10) avec lesdites sources de rayonnement lumineux (12) agencées au niveau desdits emplacements de montage (120) sur ladite surface frontale, et le couplage magnétique desdits éléments dissipateurs thermiques (14) comprenant au moins une partie magnétique (14a) avec la surface dorsale du substrat semblable à un ruban (10) au niveau desdits emplacements opposés auxdits emplacements de montage (120) sur ladite surface frontale avec lesdites sources de rayonnement lumineux (12) agencées à cet endroit, avec le substrat semblable à un ruban (10) pris en sandwich entre l'élément dissipateur thermique (14) et l'élément complémentaire (16).
